(19) Europäisches Patentamt
European Patent Office
Office européen des brevets

(11) Publication number: **0 366 937 A2**

(12) **EUROPEAN PATENT APPLICATION**

(21) Application number: **89118050.7**

(51) Int. Cl.[5]: **G03F 7/38**

(22) Date of filing: **29.09.89**

(30) Priority: **31.10.88 US 264911**

(43) Date of publication of application: **09.05.90 Bulletin 90/19**

(84) Designated Contracting States: **DE FR GB**

(71) Applicant: **International Business Machines Corporation**
**Old Orchard Road**
**Armonk, N.Y. 10504(US)**

(72) Inventor: **Flagello, Donis George**
**51 Tackora Trail**
**Ridgefield, CT 06877(US)**
Inventor: **Hatzakis, Michael**
**12 Hunting Ridge Place**
**Chappaqua N.Y. 10514(US)**
Inventor: **Cunningham Noe, Susan**
**8028 Lilly Stone Drive**
**Bethesda, MD 20817(US)**
Inventor: **Shaw, Jane Margaret**
**336 Wilton Road West**
**Ridgefield, CT 06877(US)**
Inventor: **Witman, David Frank**
**75 Summit Place**
**Pleasantville, N.Y. 10570(US)**

(74) Representative: **Oechssler, Dietrich, Dr. rer. nat.**
**IBM Deutschland GmbH Patentwesen und Urheberrecht Schönaicher Strasse 220**
**D-7030 Böblingen(DE)**

(54) **Method of forming relief patterns and use thereof.**

(57) A relief pattern is formed by exposing a portion of a photosensitive layer of polymeric material having reactive hydrogen functional groups and/or reactive hydrogen functional precursor groups to actinic light and then contacting the layer with a multifunctional organometallic material containing at least two functional groups which are reactive with the reactive hydrogen groups of the polymeric material to thereby render the thickness of the layer at the exposed portion different from the thickness of the layer at the unexposed portion. The relief pattern can, in turn, be used in optical disks to fabricate the servo-tracks. Also, the relief pattern can be used for producing a lithography mask for dry etching.

EP 0 366 937 A2

## Method of Forming Relief Patterns and Use Thereof

The present invention is concerned with producing a relief pattern. The patterns of the present invention can be used for recording information, such as servo-tracks for optical memory disks. In addition, the patterns of the present invention can be used to provide lithography masks.

In optical recording, relief images are formed in the form of pits in the recording medium which can be an inorganic or organic layer by a laser beam focused onto the surface of the recording medium. This pit formation can be accomplished by laser ablation of the recording layer or by photochemical means with organic active layers such as photoresists. The latter method is preferable because of the lower power required to effect a thickness change by photochemical means.

In addition, a similar pit-forming layer is placed under the recording medium onto which a predetermined pit structure is formed that will be used for servo-tracking or pre-formatting of the disk. Again, this layer can be inorganic, as in the case when the glass substrate is pre-etched to form the servo-tracks, or it can be a photochemically active organic layer that is fixed or stabilized against solvent attack and heating after the servo or pre-formatting information is recorded on it.

For additional information see, for example, James E. Kuder, Journal of Imaging Science, Vol. 32, pages 51-56, 1988.

In the manufacture of patterned devices, such as semiconductor chips and chip carriers, the processes of etching different layers which constitute the finished product are among the most crucial steps involved. One method widely employed in the etching process is to overlay the surface to be etched with a suitable mask and then to immerse the substrate and mask in a chemical solution which attacks the substrate to be etched while leaving the mask intact. These wet chemical processes suffer from the difficulty of achieving well-defined edges on the etched surfaces. This is due to the chemicals undercutting the mask and the formation of an isotropic image. In other words, conventional chemical wet processes do not provide the selectivity of direction (anisotropy) considered necessary to achieve optimum dimensional control consistent with current processing requirements.

Moreover, such wet etching processes are undesirable because of the environmental and safety concerns associated therewith.

Accordingly, various so-called "dry processes" have been suggested to improve the process from an environmental viewpoint, as well as to reduce the relative cost of the etching. Furthermore, these "dry processes" have the potential advantage of greater process control and higher aspect ratio images.

Such "dry processes" generally involve passing a gas through a container and creating a plasma in this gas. The species in this gas are then used to etch a substrate placed in the chamber or container. Typical examples of such "dry processes" are plasma etching, sputter etching, and reactive ion etching.

Reactive ion etching provides well-defined, vertically etched sidewalls. A particular reactive ion etching process is disclosed, for example, in U.S. Patent 4,283,249 to Ephrath, disclosure of which is incorporated herein by reference.

One problem associated with "dry processing" techniques is providing a patternable material which is sensitive to imaging radiation while, at the same time, being sufficiently resistant to the dry-etching environment. In many instances, resistance to the dry-etching such as to the plasma etching active species results in erosion of the mask material and loss of resolution of the material employed for preparing the mask in the lithographic exposure to the imaging radiation.

This is true for both positive organic resist materials and negative organic resist materials. A positive resist material is one which, on exposure to imaging radiation, is capable of being rendered soluble in a solvent in which the unexposed resist is not soluble. A negative resist material is one which is capable of polymerizing and/or insolubilizing upon exposure to imaging radiation.

One type of positive photosensitive material is based upon phenolic formaldehyde novolak polymers. A particular example of such is Shipley AZ-1350® which is an m-cresol formaldehyde novolak polymer composition. Such is a positive resist composition and includes therein a diazoketone such as 2-diazo-1-naphthol-5-sulphonic acid ester. In such a composition the diazoketone, during the photochemical reaction is converted to a carboxylic acid. This, in turn, converts a neutral-organic soluble molecule (the phenolic polymer) to one that is readily soluble in weakly alkali aqueous developer solvents. The composition usually contains about 15% or so, by weight, of the diazoketone compound. More recently, certain phenolic formaldehyde novolak polymer compositions have been introduced, such as the Shipley AZ-5200® series that can act as either positive or negative resist, depending upon the processing employed. For example, a baking step after exposure provides for a negative resist.

A discussion of the various photoresist materials can be found, for instance, in Journal of the

Electrochemical Society, Vol. 125, No. 3, March 1980, Deckert, et al., "Microlithography - Key to Solid-State Fabrication", pp. 45C-56C, disclosure of which is incorporated herein by reference.

Certain siloxanes have been suggested as reactive ion etch barriers. For instance, see Fried, et al., IBM Journal Research Development, Vol. 26, No. 8, pp. 362-371. Also, certain siloxanes have been suggested as e-beam sensitive resists. For instance, see Roberts, Journal of Electrochemical Society, Vol. 120, p. 1716, 1973; Roberts, Phillips Technical Review, Vol. 35, pp. 41-52, 1975; and Gazard, et al., Applied Polymer Symposium, No. 23, pp. 106-107, 1974.

Moreover, there have been suggestions that certain siloxanes, when imaged with electron beam (see Hatzakis, et al., Processing Microcircuit Engineering, Lausanne, p. 396, September 1981) and deep U.V. at about 2537 angstrom (see Shaw, et al., SPE Photopolymer Conference, November 1982) act as an etch mask for an underlying polymer layer in an oxygen plasma. However, these siloxane materials suggested require very limited methods for imaging (e.g., e-beam and deep U.V.) and are not imageable with radiation of longer wavelengths (e.g., greater than 270 nm) where the majority of lithographic imaging tools, contact proximity, and projection printers operate.

U.S. Patent 4,603,195 to Babich, et al. discloses materials which are resistant to dry-processing techniques and especially to reactive ion etching in oxygen plasma while, at the same time, capable of providing high resolution images. The compositions disclosed therein are obtained by interacting a quinone diazo compound and an organosilicon compound and functions as negative resist materials.

In addition, examples of some dry-developable resists are provided in U.S. Patents 4,426,247 to Tamamura, et al.; 4,433,044 to Meyer, et al.; 4,357,369 to Kilichowski, et al.; 4,430,153 to Gleason, et al.; 4,307,178 to Kaplan, et al.; 4,389,482 to Bargon, et al.; and 4,396,704 to Taylor. Further, German patent application OS 32 15082 (English language counterpart British patent application 2097143) suggests a process for obtaining negative tone plasma resist images. Such is concerned with a process involving entrapment of a silicon-containing monomer into a host film at the time of exposure to radiation and requires a processing step to expel the unincorporated silicon monomer from the film before plasma developing of the relief image.

A more recent example of a plasma developable resist is described in U.S. Patent 4,552,833 to Ito, et al. in which a method is provided for obtaining a resist which is stated to be radiation sensitive and oxygen plasma developable. Such process involves coating a substrate with a film of a polymer that contains a masked reactive functionality; imagewise exposing the film to radiation under conditions that cause unmasking of the reactive functionality in the exposed regions of the film; treating the exposed film with a reactive organometallic reagent; and then developing the relief image by treatment with an oxygen plasma. The specific organometallic reagents described therein are trimethylstannyl chloride, hexamethyldisilazane, and trimethylsilyl chloride.

In addition, a method of obtaining a two-layer resist by top imaging a single layer resist is described in European Patent Application No. 0,186,798, assigned to the assignee of the present application) which employs a monofunctional organometallic reagent.

Moreover, U.S. Patent 4,782,008 (assigned to the assignee of the present application) describes oxygen plasma resistant materials obtained by reacting a polymeric material with a multifunctional organometallic material.

The organometallic material contains at least two functional groups which are reacted with reactive groups of the polymeric material. The polymeric material contains reactive hydrogen functional groups and/or reactive hydrogen functional precursor groups.

Disclosures of the above two U.S. patent applications are incorporated herein by reference.

A further disclosure of photosensitive compositions containing organosilicon compounds can be found in U.S. Patent 4,693,960.

U.S. Patent 4,464,455 to Yoneda, et al. discusses a dry developing negative resist composition containing a hydrocarbon polymer mixed with 1% to 70% by weight of a silicone compound. Yoneda, et al. suggest that a negative resist pattern can be formed by coating a substrate with the resist composition, exposing the resist layer to ionizing radiation, and then subjecting the layer to a relief treatment to remove the non-irradiated silicone compound. The resist pattern is then developed by treatment with a gas plasma. The relief treatment may consist of heating the exposed resist layer or subjecting the exposed layer to a vacuum.

U.S. Patent 4,551,418 to Hult, et al. discusses producing negative relief images by coating a substrate with a film of cationic photoinitiator and exposing the film to a radiation image to generate cationic initiators in the exposed regions of the film. The exposed film is then treated with a cationic-sensitive monomer to produce a polymer which is resistant to plasma etching in the exposed regions of the film. The film is etched by a plasma treatment to remove the unexposed regions.

The monomer can be an organometallic monomer such as a cyclosiloxane or other silicon-containing organometallic compound. For example, Hult, et al. suggest that the organometallic compound may be 4-vinyl-phenyl-t-butyldimethylsilyl ether in petroleum ether.

U.S. Patents 4,588,675 and 4,590,149 to Nakane, et al. are concerned with forming a fine pattern from a photoresist layer. These patents to Nakane, et al. suggest forming a layer of a negative-type photoresist of a polymer and an azide compound on one surface of a substrate. The photoresist layer is irradiated with a radiation image of actinic rays (e.g., electron beams, ion beams, X-rays, or ultraviolet light). The exposed photoresist layer is then heated at a temperature from 200° C to 500° C by applying heat to the surface of the substrate which is not coated with the photoresist. The photoresist layer is then exposed to an atmosphere of a plasma gas to decompose and remove the photoresist in the areas not irradiated.

It is an object of the present invention to provide a method for forming high resolution relief patterns that are stable at high temperatures and resistant against organic solvents.

It is another object of the invention to provide a method for forming lithography masks that are resistant to dry etching.

These objects are achieved by methods as disclosed in claims 1 and 2.

The relief patterns of the present invention can be used for recording information, such as servo-tracks for optical memory disks. The patterns can be left in place. Also, the relief patterns of the present invention are capable of being dry-developed such as in an oxygen plasma or reactive ion etching using oxygen.

The lithography masks produced according to the present invention are suitable for use in device fabrication on all optical, e-beam, X-ray, and ion-beam lithography tools and for packaging applications such as multilayer ceramic packaging devices. They are resistant to oxygen-containing plasma.

Advantageous embodiments of the inventive methods are disclosed in the subclaims.

The invention will become more apparent from the following detailed description.

The polymeric materials employed in the present invention include a number of different types of materials, provided such contain reactive hydrogen functional groups and/or groups which act as precursors to reactive hydrogen functional groups. For instance, the polymeric material can contain moieties which are labile such that upon subjection to certain conditions, such as irradiation, will produce reactive hydrogen functional groups. As used herein, the term "hydrogen functional groups" includes normal hydrogen function groups, as well as its isomer, deuterium functional groups with normal hydrogen being preferred.

Examples of polymers having reactive hydrogen functional groups include prepolymerized phenol-formaldehyde polymers which can be prepared by the acid or base catalyzed condensation of formaldehyde with an excess of a phenol having the formula:

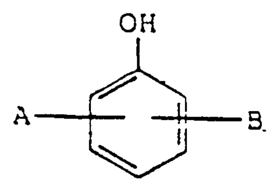

wherein A and B, individually, are hydrogen or alkyl group containing 1-6 carbon atoms. Such phenolic formaldehyde polymers are referred to as novolak polymers. In addition, such phenol-novolak compositions can contain a diazo ketone sensitizer as shown in the art. Such sensitizers and polymers are described, for example, in U.S. Patents 3,046,118; 3,046,121; 3,106,465; 3,201,239; and 3,666,473, disclosures of which are incorporated herein by reference.

The sensitizers are diazo ketones having diazo and keto group at adjacent positions on the molecules such as the naphthoquinone-(1,2)-diazide sulfonic acid esters which are reported in U.S. Patent 3,201,239 which has the formula:

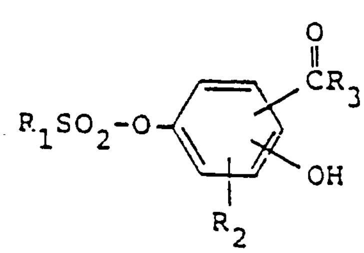

in which $R_1$ is a naphthoquinone-(1,2)-diazide radical, $R_2$ is selected from the group of hydrogen and hydroxyl, and $R_3$ is from the group of hydrogen, alkyl, aryl, alkoxy, aryloxy, amino, and heterocyclic groups.

Examples of sensitizers are also reported in U.S. Patent 3,046,118 which has the formula:

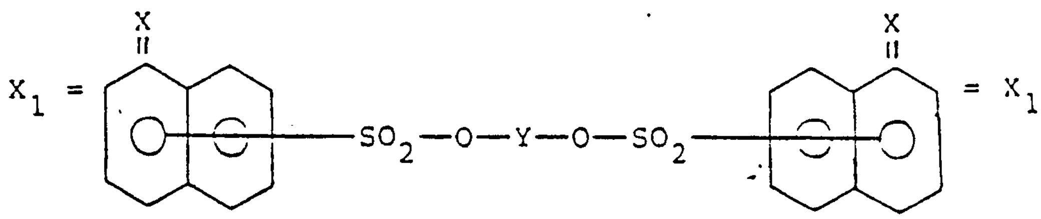

wherein X and $X_1$ are $N_2$ or O, those attached to the same ring being different, and Y is an organic linkage containing at least one arylene, substituted arylene, or heterocyclic radical; U.S. Patent 3,046,121 which has the formula:

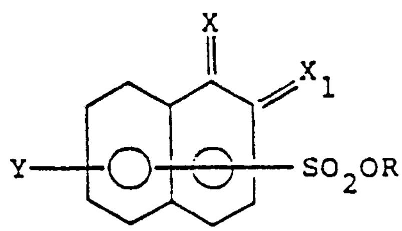

wherein X and $X_1$ are from the group of $N_2$ and O and are different. Y is hydrogen or halogen and R is a substituted or unsubstituted aryl or heterocyclic radical; and U.S. Patent 3,106,465 which has one of the formula:

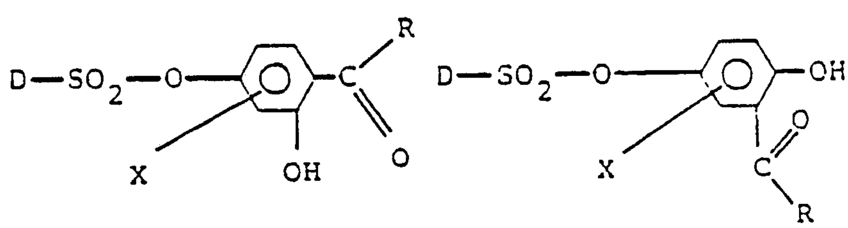

wherein D stands for naphthoquinone-(1,2)-diazide radical; X stands for H or OH; R stands for a member of the group of hydrogen, $OR_1$, $NR_2R_3$, alkyl-, aryl-, and heterocyclic radicals; $R_1$ is an alkyl or aryl; $R_2$ and $R_3$ are a hydrogen alkyl or aryl, $R_2$ equaling $R_3$ or being different from $R_3$.

Examples of such compounds are 2,3,4-trihydroxybenzophenone esters of 1-oxo-2-naphthalene-5 sulfonic acid. The sensitizers, when used, are generally employed in amounts of about 12% to about 30% by weight of the polymeric components of the composition.

Examples of reactive hydrogen functional groups include OH, COOH, NH, and SH groups. Also, epoxide groups which are capable of undergoing ring opening and forming OH groups are suitable reactive hydrogen functional precursor groups.

Examples of other polymers include polyimides, polyvinylpyrrolidone, polyvinylalcohol, polymers of p-hydroxystyrene, melamino polymers, homopolymers, and copolymers of monoethylenically unsaturated acids, copolymers of alkyl methacrylates containing about 1-4 carbon atoms in the alkyl group, and a monoethylenically unsaturated acid. The monoethylenically unsaturated acid can be acrylic acid, methacrylic acid, or crotonic acid. Usually, the polymer contains from about 50 to about 99.5 mole percent of the alkyl methacrylate and about 50 to about 0.5 mole percent of the unsaturated acid. These mole percents are based upon the total moles of the alkyl methacrylate and acid in the polymer. Examples of such polymers can be found in U.S. Patent 3,984,582, disclosure of which is incorporated herein by reference.

Polymers containing labile groups which are capable upon excitation, such as upon irradiation of generating reactive hydrogen groups, include O-nitrobenzene derivatives and polymers capable of photo-fries rearrangement. Upon irradiation, acids, alcohols, and/or amines with reactive hydrogens are generated. Examples of such materials are:

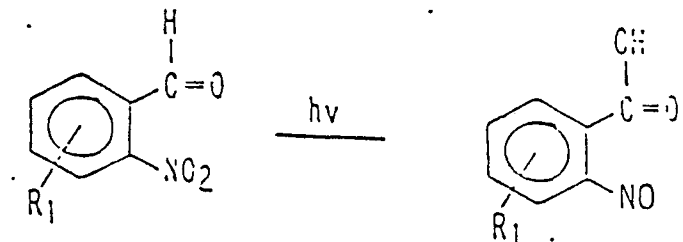


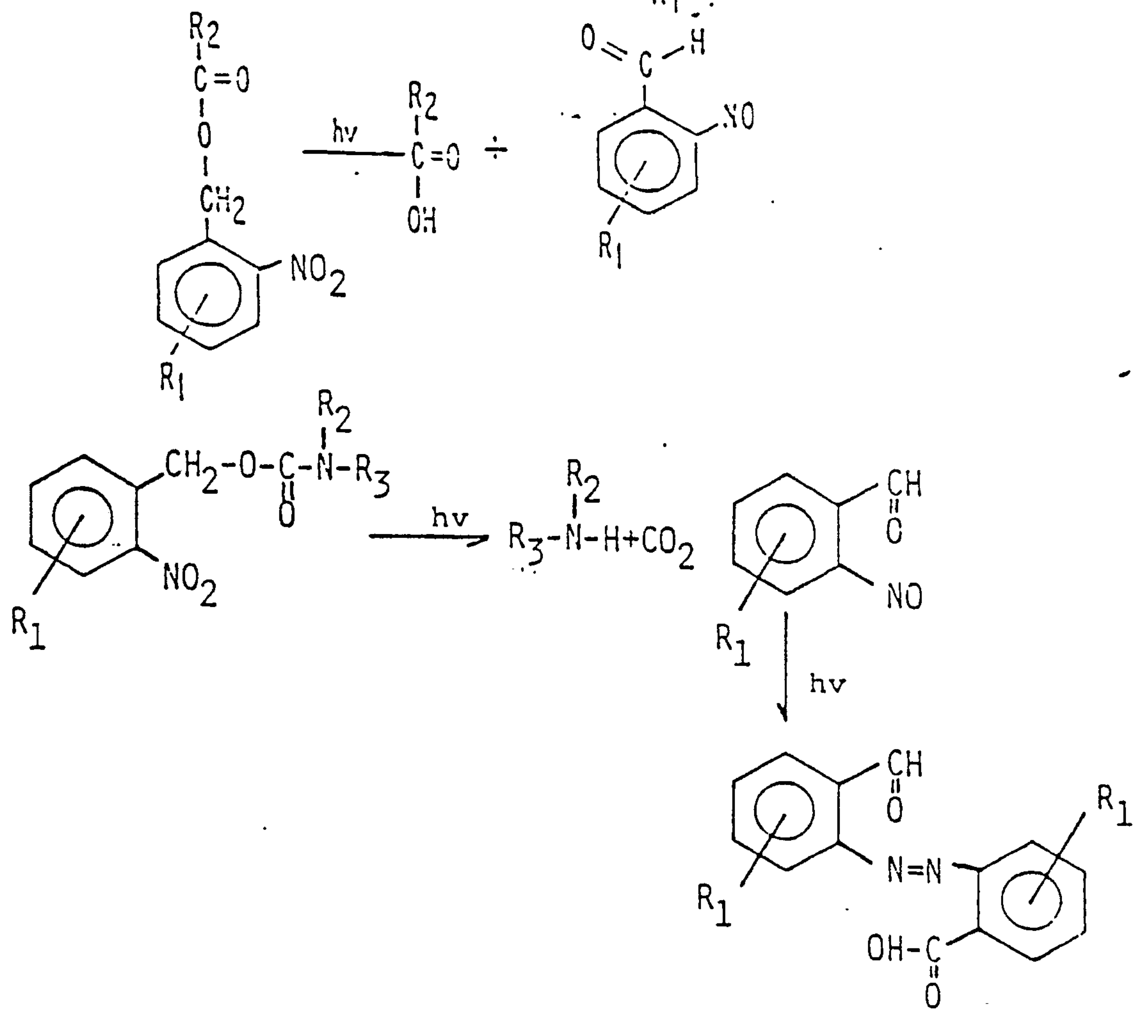


wherein $R_1$, $R_2$, $R_3$, and $R_5$ = H, alkyl, aryl, or part of a polymer backbone and $R_4$ = H, $C_nH_{2n+1}$ wherein n ranges from 1 to about 5 phenyl or substituted phenyls.

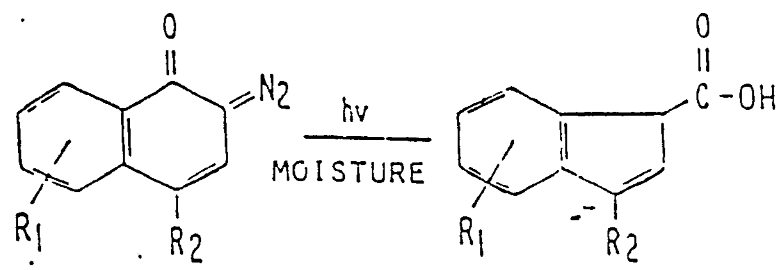


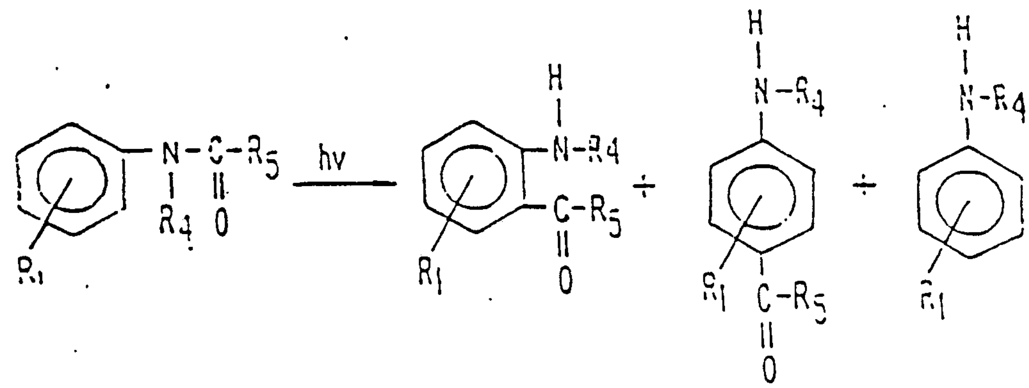


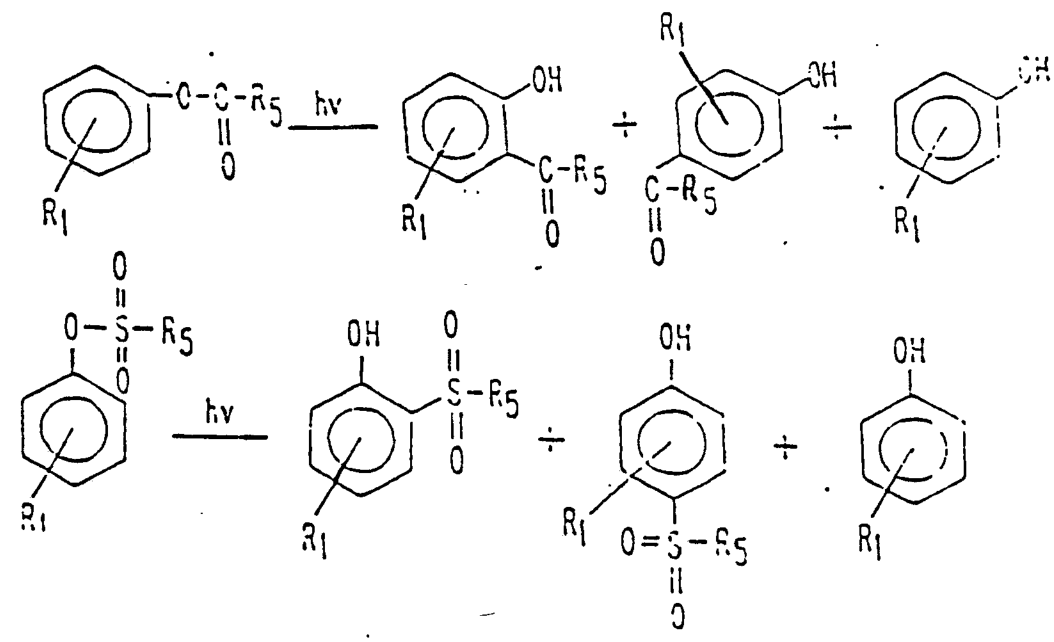


wherein $R_1$, $R_2$, $R_3$, and $R_5$ = H, alkyl, aryl, or part of a polymer backbone and $R_4$-H, $C_nH_{2n+1}$ wherein n ranges from 1 to about 5, phenyl or substituted phenyls.

Materials of the above type can be used alone or in combination with compatible polymeric materials. Compounds such as substituted O-nitrobenzaldehyde, esterified phenols, and diazoquinone derivatives can be mixed together with polymers which have no labile or reactive hydrogens. For example, polymethylmethacrylate, styrene-butadiene rubbers, polymethylisopropenyl ketone (PMIPK), and polystyrene and its derivatives. Upon irradiation, the molecules which are sensitive to the irradiation undergo rearrangement to yield products with labile and reactive hydrogens. The labile and reactive hydrogens are then subsequently reacted with an organometallic reagent pursuant to the process of the present invention.

Examples of such particular polymers include acetylated polyvinylphenol, poly(p-formyl)oxystyrene, copolymers prepared from p-formyl oxystyrene, poly(t-butyl)methacrylate, poly(t-butyloxycarbonyloxystyrene), and copolymers from t-butylmethacrylate or t-butyloxycarbonyloxystyrene. Disclosures of such polymers can be found in European Patent Application No. 0,186,798., U.S. Patent No. 4,552,833 and

European Patent Application No. 0,195,291, disclosures of which are incorporated herein by reference.

The multifunctional organometallic material employed pursuant to the present invention must contain or be capable of supplying at least two functional groups which are reactive with the reactive groups of the polymeric material.

Examples of suitable metallic portions of the organometallic material are Group III A metals, Group IV A metals, Group IV B metals, and Group VI B metals. Examples of Group IV A metals are tin, germanium, and silicon. Examples of Group IV B metals are titanium and zirconium. Examples of Group VI B metals are tungsten and molybdenum. An example of a Group III A metal is aluminum. The preferred metallic portions are titanium, silicon, and tin, with the most preferred being silicon.

The reactive groups of the organometallic compound include such reactive groups as hydroxy, amino, mercapto, and halogen; and groups capable of supplying reactive groups include alkoxy groups such as methoxy and ethoxy which hydrolyze to form OH groups.

Examples of suitable organometallic compounds include the following:

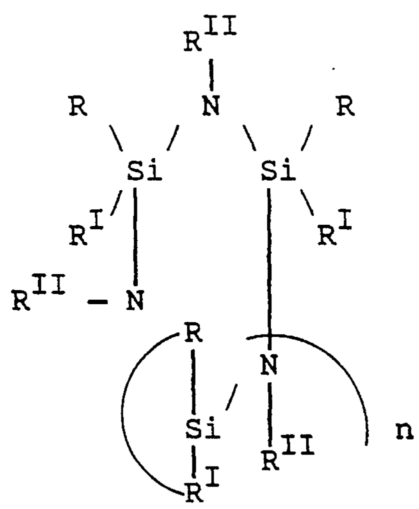

1.

wherein each R and $R^I$, individually, is H, alkyl, cycloalkyl, aryl, halo-substituted alkyl, each $R^{II}$, individually, is H, alkyl, or aryl, and n is a whole number integer ≥1 and preferably 1 or 2.

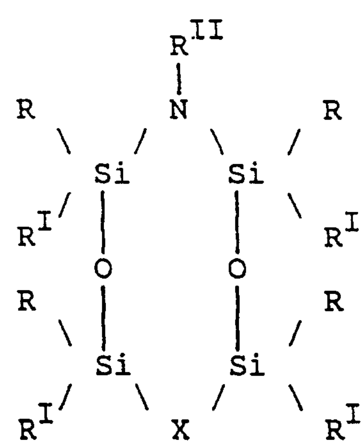

2.

halo, or halo-substituted aryl; each $R^{II}$, individually, is H, alkyl, or aryl; and X is O, Si, or N-R$''$.

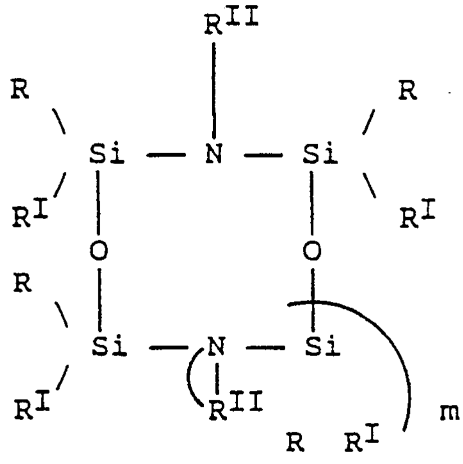

3.

wherein each R and $R^{I}$, individually, is H, alkyl, cycloalkyl, aryl, halo, halo-substituted alkyl, or halo-substituted aryl; each $R^{II}$, individually, is H, alkyl, or aryl; and m is a whole number integer ≧1 and preferably 1 or 2.

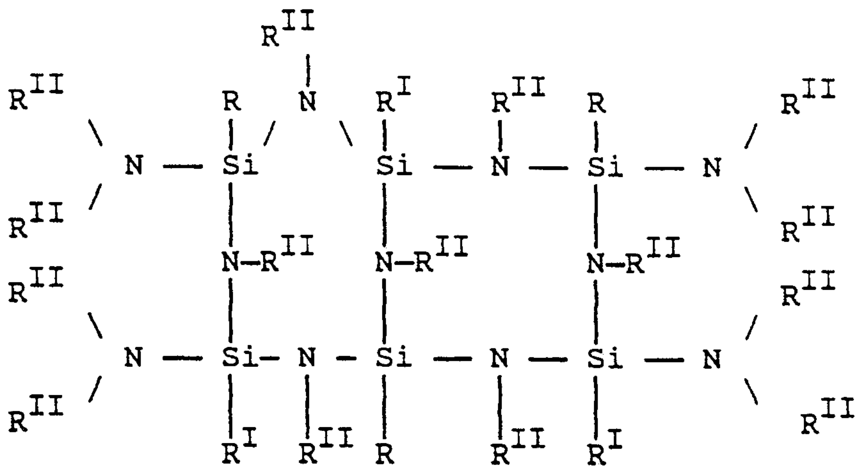

4.

wherein each R and $R^{I}$, individually, is H, alkyl, cycloalkyl, aryl, halo, halo-substituted alkyl, or halo-substituted aryl; and each $R^{II}$, individually, is H, alkyl, or aryl.

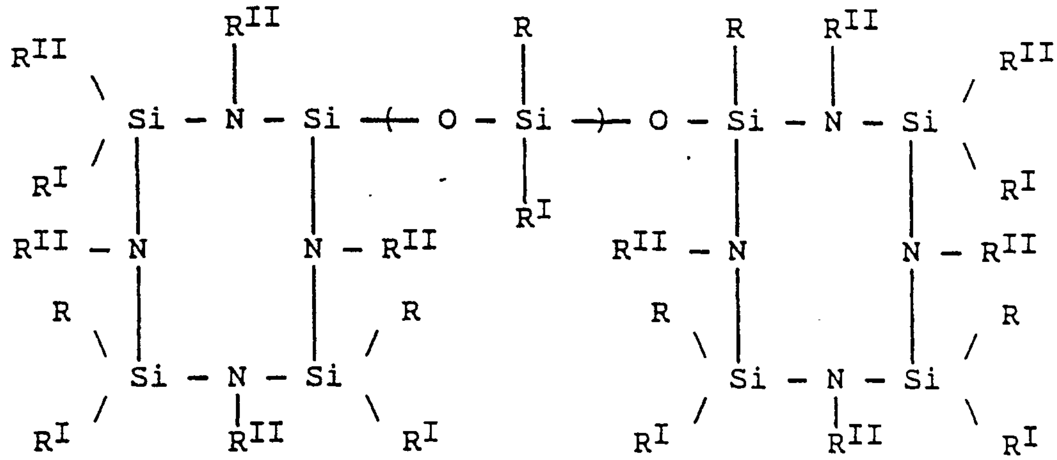

5.

wherein each R and $R^I$, individually, is H, alkyl, cycloalkyl, aryl, halo, halo-substituted alkyl, or halo-substituted aryl; each $R^{II}$, individually, is H, alkyl, or aryl; and p is a whole number integer of ≧1 and preferably 1-4.

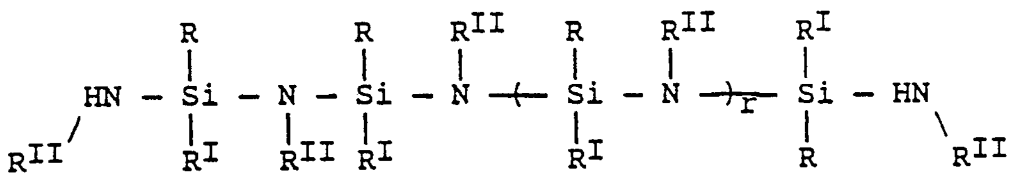

6.

wherein each R and $R^I$, individually, is H, alkyl, cycloalkyl, aryl, halo, halo-substituted alkyl, or halo-substituted aryl; each $R^{II}$, individually, is H, alkyl, or aryl; and r is a whole number integer of 0-$10^2$, preferably 1-4.

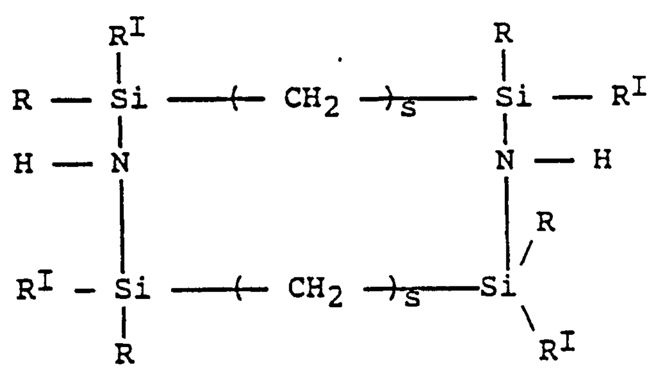

7.

wherein each R and $R^I$, individually, is H, alkyl, cycloalkyl, aryl, halo, halo-substituted alkyl, or halo-substituted aryl; and each s, individually, is a whole number integer ≧1, and preferably 1 or 2.

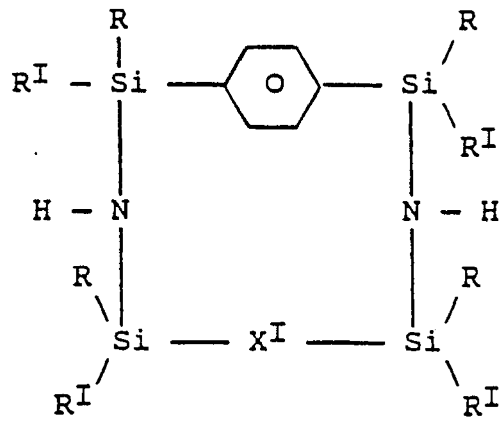

8.

wherein each R and $R^I$, individually is H, alkyl, cycloalkyl, aryl, halo-substituted alkyl, halo-substituted aryl, or halo; and $X^I$ is $(-CH_2-)_t$, or

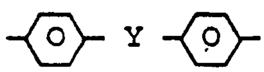

wherein t is a whole number integer ≧1 and preferably 1-4; and Y is O, NH, or S.

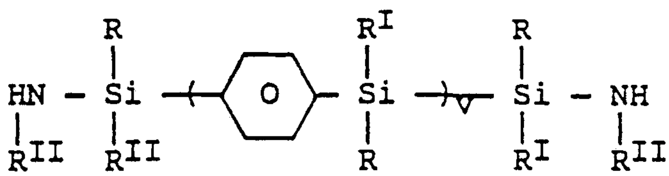

9.

wherein each R and $R^I$, individually, is H, alkyl, cycloalkyl, aryl, halo, halo-substituted alkyl, or halo-substituted aryl; and v is a whole number integer of ≧1 and preferably 1-4.

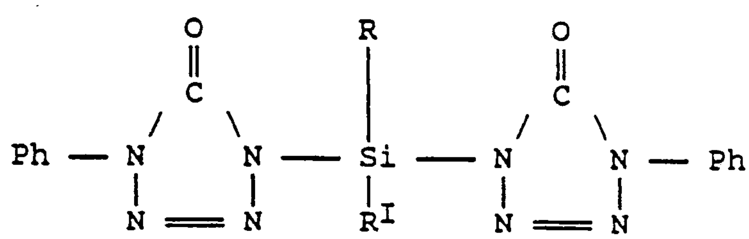

10.

wherein each R and $R^I$, individually, is H, alkyl, cycloalkyl, aryl, halo, halo-substituted alkyl, or halo-substituted aryl.

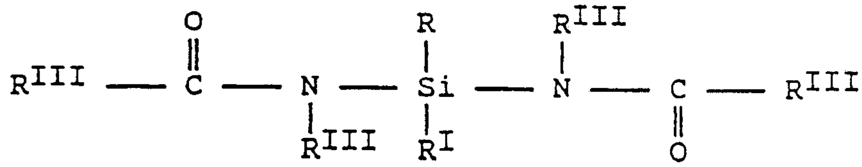

11.

wherein each R and $R^I$, individually, is H, alkyl, cycloalkyl, aryl, halo, halo-substituted alkyl, or halo-substituted aryl, and each $R^{III}$, individually, is alkyl.

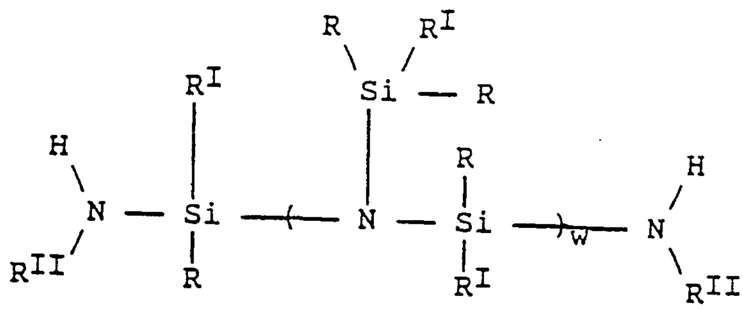

12.

wherein each R and $R^I$, individually, is H, alkyl, cycloalkyl, aryl, halo, halo-substituted alkyl, or halo-substituted aryl, each $R^{II}$, individually, is H, alkyl, or aryl; and w is a whole number ≥1 and preferably 1-4.

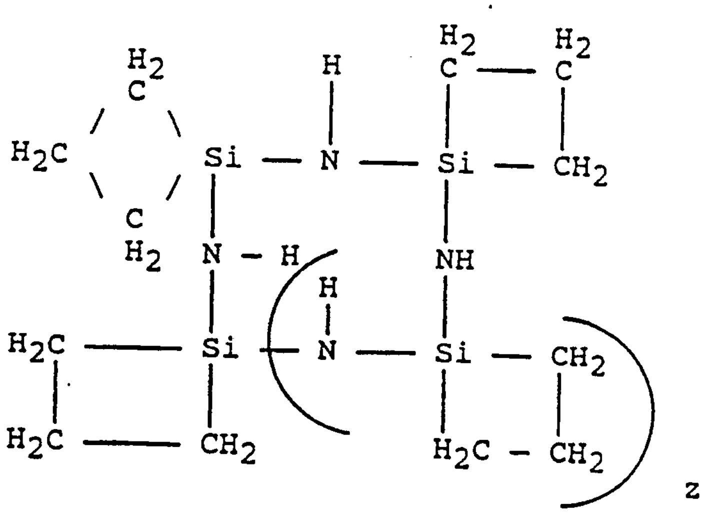

13.

wherein z is a whole number integer of 0-4 and preferably 0-2.

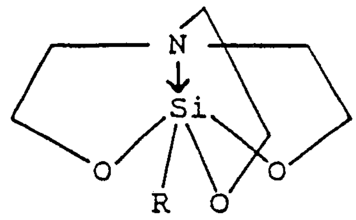

14.

wherein R is H, alkyl, cycloalkyl, aryl, halo, halo-substituted alkyl, or halo-substituted aryl.

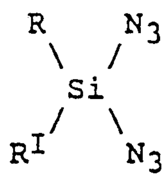

15.

wherein each R and $R^I$, individually, is H, alkyl, cycloalkyl, aryl, halo, halo-substituted alkyl, or halo-substituted aryl.

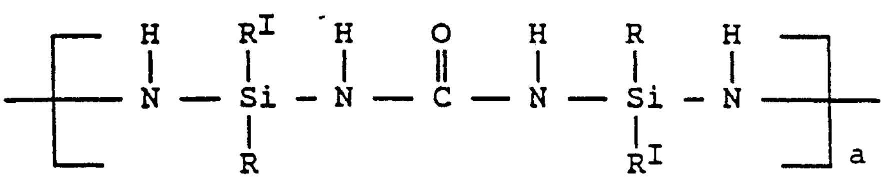

16.

wherein each R and $R^I$, individually, is H, alkyl, cycloalkyl, aryl, halo, halo-substituted alkyl, or halo-substituted aryl; and a is a whole number integer ≥1 and preferably 1-4.

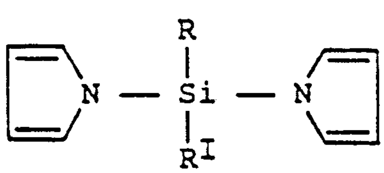

17.

wherein each R and $R^I$, individually, is H, alkyl, cycloalkyl, aryl, halo, halo-substituted alkyl, or halo-substituted aryl.

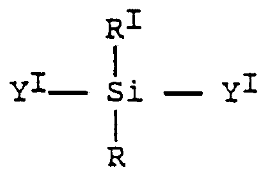

18.

wherein each $Y^I$, individually, is

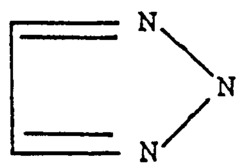 or 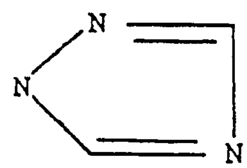 ,

and

R and $R^I$, individually, is H, alkyl, cycloalkyl, aryl, halo, halo-substituted alkyl, or halo-substitutcd aryl.

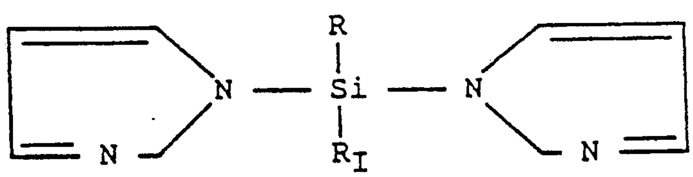 ,

19.

and

wherein each R and $R^I$, individually, is H, alkyl, cycloalkyl, aryl, halo, halo-substituted alkyl, or halo-substituted aryl.

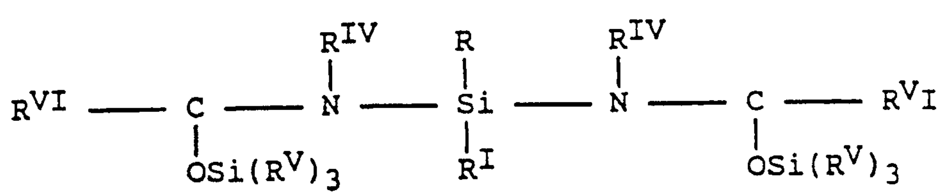

20.

wherein each R and $R^I$, individually, is H, alkyl, cycloalkyl, aryl, halo, halo-substituted alkyl, or halo-substituted aryl; each $R^{IV}$, individually, is H or alkyl; each $R^V$, individually, is H or alkyl; and each $R^{VI}$, individually, is alkyl or $CX_3$(X = F, Cl, Br, I).

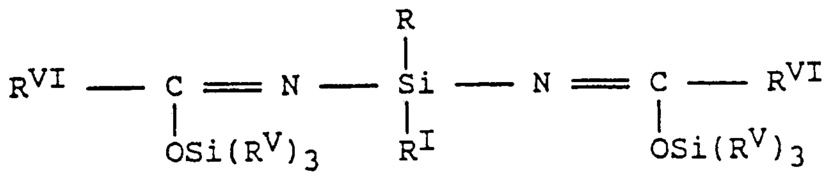

21.

wherein each R and $R^I$, individually, is H, alkyl, cycloalkyl, aryl, halo, halo-substituted alkyl, or halo-substituted aryl; each $R^{IV}$, each $R^V$, individually, is H or alkyl; and each $R^{VI}$. individually, is alkyl or $CX_3$-($X = F, Cl, Br, I$).

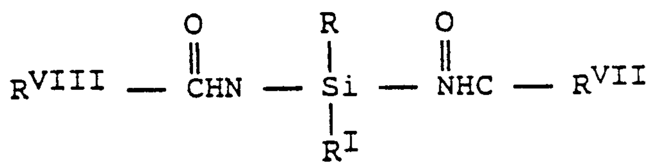

22.

wherein each R and $R^I$, individually, is H, alkyl, cycloalkyl, aryl, halo, halo-substituted alkyl, or halo-substituted aryl; and each $R^{VII}$, individually, is alkyl.

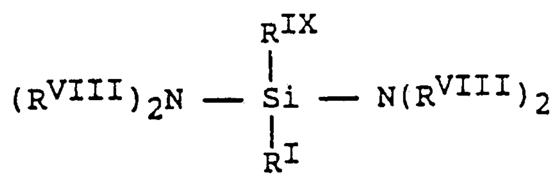

23.

wherein each $R^{IX}$, individually, is alkyl; and each $R^{VIII}$, individually, is alkyl.

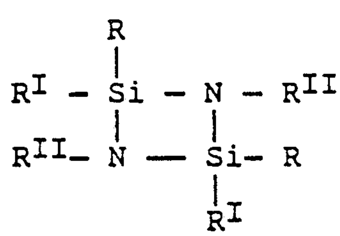

24.

wherein each R and $R^I$, individually, is H, alkyl, cycloalkyl, aryl, halo, halo-substituted alkyl, or halo-substituted aryl; and each $R^{II}$, individually, is alkyl or aryl.

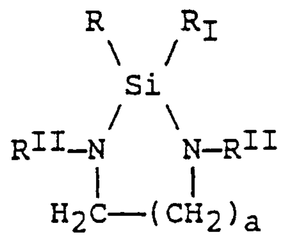

25.

and dimers and polymers thereof wherein each R and $R^I$, individually, is H, alkyl, cycloalkyl, aryl, halo-substituted alkyl, halo, or halo-substituted aryl; each $R^{II}$, individually, is H, alkyl or aryl; and a is 1, 2, or 3.

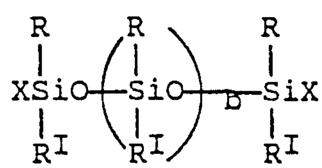

26.

wherein b is a whole number integer of 1-5; each R and $R^I$, individually, is H, alkyl, cycloalkyl, aryl, halo-substituted alkyl, halo, or halo-substituted aryl; each X, individually, is halo, SH, OH, $OR^x$, and NH and $R^x$ is alkyl, 1-5 carbon atoms, and preferably ethyl or methyl.

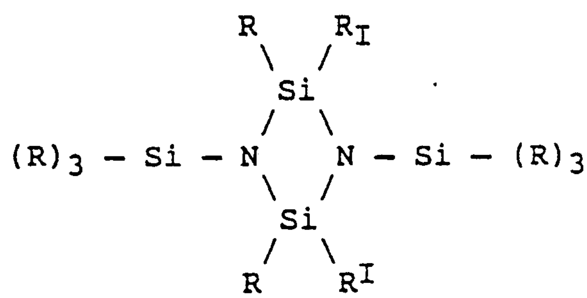

27.

wherein each R and $R^I$, individually, is H, alkyl, cycloalkyl, aryl, halo-substituted alkyl, halo, or halo-substituted aryl.

Examples of suitable alkyl groups in the above formulas are alkyl groups containing 1-12 carbon atoms and preferably 1-4 carbon atoms. Specific examples of such are methyl, ethyl, propyl, butyl, and octyl. The most preferred alkyl groups are methyl and ethyl.

Examples of suitable cycloalkyl groups are cyclohexyl and cycloheptyl.

Examples of suitable aryl groups are phenyl, tolyl, xylyl, and naphthyl radicals.

Examples of suitable halo radicals are F, Cl, Br, and I.

Examples of suitable halo-substituted alkyl groups are 1,1,1-trifluoropropyl and chloromethyl.

Examples of suitable halo-substituted aryl groups are chlorophenyl and dibromophenyl.

In many applications of the use of the products of the present invention it is preferred that the organometallic compound not include any halogen component, such as chlorine, to assure against the possibility of causing corrosion due to the potential formation of some corrosive halide gas.

The preferred organometallic compounds are the cyclic organo silicon compounds and more preferably hexamethylcyclotrisilazane.

The process of the present invention comprises providing a photosensitive layer of the polymeric material such as by applying such to a desired substrate usually about 1500 angstroms to about 1 mil thick, such as by spraying, dipping, or any other known means of application of coating. Some suitable substrates include those used in the fabrication of semiconductor devices or integrated circuits which include wafers or chips overcoated with oxides and nitrides (silicon oxide and/or silicon nitride for diffusion masks and passivation) and/or metals normally employed in the metallization steps for forming contacts and conductor patterns on the semiconductor chip, or polymeric substrates.

In the event the polymeric material has reactive hydrogen functional precursor groups, the polymeric material is treated to convert the precursor groups to reactive hydrogen functional groups as known.

A portion or pattern less than the entire layer of the polymeric material is exposed to actinic light to change the quantity of hydrogen functional groups in the exposed portion of the layer. The actinic light can be ultraviolet light, including near-U.V., mid-U.V., and deep-U.V., X-ray beam radiation, neutron radiation, or electron-beam radiation. The preferred actinic light for any particular polymer composition will depend upon the specific composition and can be readily determined by those skilled in the art without undue experimentation once aware of the present disclosure.

For instance, the phenol-formaldehyde polymers are preferably exposed with e-beam or ultraviolet light (usually, the wavelength employed is at least about 240 nanometers and preferably about 350 to about 450 nanometers) at exposure energy range of at least about 50 millijoules/$cm^2$ and most preferably about 100 to about 200 millijoules/$cm^2$.

When it is desired to employ the phenolic-formaldehyde type materials as negative photosensitive material, the layer is heated after exposure to temperatures of about 90 °C to about 130 °C for about 2 minutes to about 30 minutes and preferably about 105 °C to about 125 °C for about 2 to about 5 minutes.

Next, the layer (i.e., both exposed and unexposed ortions) is contacted without a prior development step with the multifunctional organometallic material disclosed above.

The amount of the organometallic material employed must be sufficient to provide the desired degree of crosslinking, plasma resistance, and increased thickness of the unexposed portion. Usually, the relative amount of the organometallic material to the polymeric material provides at least about 1 part by weight of the metallic component (e.g., Si) per 20 parts of the polymeric material, and up to about 1 part by weight of the metallic component per 2 parts by weight of the polymeric material, and preferably about 1 part by weight of the metallic component per 15 parts of the polymeric material to about 1 part by weight of the metallic component per 4 parts by weight of the polymeric material.

The exposure of the polymeric material to the actinic light diminishes the available reactive hydrogen groups.

In addition, the subsequent reaction of the layer with the organometallic material results in a significant difference in the thickness of the exposed portion as compared to the unexposed portion. For instance, the unexposed portion preferably exhibits an increase in thickness of about 10-50% and most preferably about 20-30% over the original thickness compared to only a negligible increase of about 5% for the exposed portion. Although the exposed portion reacts with the organometallic material swelling of the exposed portion does not occur.

Use of multifunctional organometallic materials provides for control of the height or thickness of the relief image and for larger steps of the relief as compared to monofunctional materials. Also, the heat stability and resistance to oxygen plasma is much greater.

The organometallic material is dissolved in an organic solvent which is non-reactive with the organometallic material. It is preferred that the inert organic solvent be aprotic. The most preferred solvents are the aromatic hydrocarbons and substituted aromatic hydrocarbons including benzene, toluene, xylene, and chlorobenzene. Other solvents include N-methyl pyrrolidone; γ-butyrolactone; acetates such as butyl acetate and 2-methoxy acetate; ethers; and tetrahydrofuran. In addition, the solvent is preferably selected so that it has some ability to diffuse enough through the polymeric material to provide the needed contact between the organometallic material and polymeric material. It is preferred that this solvent be only a partial, rather than a good solvent for the polymeric material. Accordingly, the choice of the polymeric material will have some effect upon the choice of the solvent used for best results.

In the preferred aspects of the present invention the solvent component also includes a solvent in which the polymeric material is readily soluble when the major portion of the solvent component is a non-solvent or only a partial solvent for the polymeric material. The solvent for the polymeric material is employed in amounts effective to decrease the necessary reaction time between the multifunctional organometallic material and the polymeric material. The solvent for the polymeric material must be non-reactive with the multifunctional organometallic material. Examples of suitable solvents for the polymeric material to be employed are N-methyl pyrrolidone, γ-butyrolactone, and acetates such as cellosolve acetate, butyl acetate,

and 2-methoxy ethyl acetate. The solvent for the polymeric material is employed in relatively minor amounts so as not to remove or dissolve the polymeric film. Preferred amounts of the organic solvent for the polymeric material are about .01% to about 25% by volume and more preferably about 0.25% to about 5% based on the total amount of organic solvent in the liquid composition. The total amount of solvent in the liquid composition is usually about 75% to about 98% and preferably about 85% to about 95% based upon the total of the solvent and organometallic material in the liquid composition. Use of elevated temperatures also enhances the diffusion through the polymeric material.

The reaction between the organometallic material is usually carried out in about 5 minutes to about 1 hour, depending upon the relative reactivities of the materials employed, the solvent system employed, and the desired increase in thickness of the unexposed portion of the layer.

The relief pattern thus obtained can now be used to fabricate the servo-tracks for optical memory disks.

In order to obtain a lithography mask, the composite is exposed to oxygen plasma or reactive ion etching in an oxygen atmosphere to remove the thinner exposed portion of the layer, leaving remaining the pattern from the thicker unexposed portion.

For instance, the composite is placed in a reaction chamber which is then evacuated and filled with oxygen. The pressure in the reaction chamber is about 13.33 µbar and the gas is introduced into the reaction chamber at a flow rate of about 0.02 standard liters per minute. A plasma is formed in the oxygen gas by coupling radio frequency power of about 0.02 kilowatts to the plasma and is continued for about 10 minutes to about 30 minutes. The oxygen-containing plasma can be from oxygen, oxygen-inert gas mixtures (e.g., argon), oxygen-halocarbon mixtures (e.g., $CF_4$), and oxygen-hydrocarbon, as is well-known.

The time for etching is relatively long since the layer (exposed and unexposed portions) exhibits resistance to the oxygen.

The following non-limiting examples are presented to further illustrate the present invention.

## Example 1

A layer of Shipley AZ-5200® is coated onto a silicon wafer by spinning. The photoresist is prebaked at 90°C for about 10 minutes resulting in a final thickness of about 1.4 µm. The wafer is exposed imagewise to e-beam radiation at about 150 millijoules/cm2. The layer is then baked after exposure at about 125°C for about 5 minutes.

Next, the layer is reacted with hexamethylcyclotrisilazane by flooding the substrate on a spinner in a solution of 10% hexamethylcyclotrisilazane in 89% xylene and 1% N-methyl pyrrolidone for about 30 minutes at about 40°C.

The unexposed portion increases about 30% in thickness after the silylation.

This process provides a relief image in a hardened polymeric layer that can be used in optical recording disks.

## Example 2

A layer of Shipley AZ-5200 ® is coated onto a silicon wafer by spinning. The photoresist is prebaked at 90°C for about 10 minutes resulting in a final thickness of about 1.4 µm. The wafer is exposed imagewise to e-beam radiation at about 150 millijoules/cm2. The layer is then baked after exposure at about 125°C for about 5 minutes.

Next, the layer is reacted with hexamethylcyclotrisilazane by flooding the substrate on a spinner in a solution of 10% hexamethylcyclotrisilazane in 89% xylene and 1% N-methyl pyrrolidone for about 30 minutes at about 40°C.

The unexposed portion increases about 30% in thickness after the silylation.

To provide a mask, the composite is next placed in a reaction chamber which is then evacuated and filled with oxygen. The pressure in the reaction chamber is about 13.33 µbar and the gas is introduced into the reaction chamber at a flow rate of about 0.02 standard liters per minute. The oxygen is disassociated by coupling radio frequency power of about 0.2 kilowatts to the plasma and is continued for about 12 minutes to remove the exposed portion.

## Claims

1. Method for producing a relief which comprises:
providing a photosensitive layer of polymeric material wherein said polymeric material contains reactive hydrogen functional groups or reactive hydrogen functional precursor groups, or both;
exposing a portion of the layer of polymeric material to actinic light to change the quantity of hydrogen functional groups in the exposed portion of said layer;
and then contacting the layer with a multifunctional organometallic material containing at least two functional groups which are reactive with the reactive hydrogen groups of said polymeric material, thereby rendering the thickness of the layer at the exposed portion different from the thickness of the layer at the unexposed portion.

2. Method for producing a lithography mask which comprises:
providing a photosensitive layer of polymeric material wherein said polymeric material contains reactive hydrogen functional groups or reactive hydrogen functional precursor groups, or both;
exposing a portion of the layer of polymeric material to actinic light to change the quantity of hydrogen functional groups in the exposed portion of said layer;
then contacting the layer with a multifunctional material contacting at least two functional groups which are reactive with the reactive hydrogen groups of said polymer material, thereby rendering the thickness of the layer at the exposed portion different from the thickness of the layer at the unexposed portion; and
dry etching the pattern by removing the layer in the exposed portion.

3. Method according to claim 1 or 2, wherein said polymeric material is a phenolic-formaldehyde polymer with said phenolic-formaldehyde polymer containing preferably a diazo ketone sensitizer.

4. Method according to claim 1 or 2, wherein as said polymeric material containing reactive hydrogen functional precursor groups epoxides being able of undergoing ring opening or o-nitro-benzene derivatives are used.

5. Method according to any one of claims 1 to 4, wherein said polymeric material is used in combination with polymers having no labile or reactive hydrogens.

6. Method according to any one of claims 1 to 5, wherein the suitable metallic portions of the organometallic material is selected among Group III A metals, Group IV a and B metals and Group VI B metals where titanium, silicon and tin are preferred.

7. Method according to claim 6, wherein an organosilicon material is used where a cyclic organosilicon compound is preferred with hexamethylcyclotrisilazane being most preferred.

8. Method according to any one of claims 1 to 7, wherein said layer is about 0.4 to about 10 $\mu m$ thick.

9. Method according to any one of claims 1 to 8, wherein said actinic light is ultraviolet radiation or electron beam radiation where the exposure energy for said actinic light is preferably at least about 50 millijoules/$cm^2$ and most preferred 50 to about 250 millijoules/$cm^2$.

10. Method according to any one of claims 1 to 9, wherein said multifunctional organometallic material is provided as a liquid composition in a solvent for the organometallic material wherein the solvent is non-reactive with the organometallic material and preferably aprotic, and where said solvent is most preferred an aromatic hydrocarbon or substituted aromatic hydrocarbon.

11. Method according to claim 10 wherein said organometallic composition is a solution of hexamethylcyclotrisilazane in xylene containing a solvent for the polymeric material selected from the group of N-methylpyrrolidone and $\gamma$-butyrolactone.

12. Method according to any one of claims 1 to 11 including the step: heating the exposed layer at a temperature of about 90° C to about 120° C before reacting the layer with the multifunctional organometallic material.

13. Method according to any one of claims 2 to 12, wherein said dry etching comprises an oxygen plasma with said dry etching comprising preferably reactive ion etching.